# EUROPÄISCHE PATENTANMELDUNG

(11) **EP 2 320 046 A2**
(43) Veröffentlichungstag der Anmeldung: **11.05.2011**
(21) Anmeldenummer: 10013482.4
(22) Anmeldetag: 09.10.2010
(51) Int. Cl.: F01N 5/02, H01L 35/00

(54) **Thermoelektrisches Generatorenmodul und abgasführendes Bauteil**

(30) Priorität: 04.11.2009 DE 102009051949
(71) Anmelder: Benteler Automobiltechnik GmbH, 33102 Paderborn (DE)
(72) Erfinder: Richter, Björn, 33106 Paderborn (DE); Przybylski, Sven, 33104 Paderborn (DE)
(74) Vertreter: Griepenstroh, Jörg

(57) **Zusammenfassung**

Die vorliegende Erfindung betrifft ein thermoelektrisches Generatorenmodul (1) zur Anordnung mit einem abgasführenden Bauteil (2) in einem Abgasstrang (3) eines Kraftfahrzeugs, wobei das thermoelektrische Generatorenmodul (1) eine Heißseite (5) und eine Kaltseite (6) und an der Heißseite (5) ein Abschlussblech (7) aufweist. Das Abschlussblech (7) besitzt dabei eine besondere Oberflächenstruktur, beispielsweise durch eine Verrippung. An der Oberfläche (8) des Abschlussbleches (7) erfolgt durch die Strömung des Abgasstromes eine erzwungene Konvektion und folglich ein Wärmeübergang von dem Abgasstrom in das Abschlussblech (7).

## Beschreibung

Die vorliegende Erfindung betrifft ein thermoelektrisches Generatorenmodul zur Anordnung in einem abgasführenden Bauteil in einem Abgasstrang eines Kraftfahrzeuges, wobei das thermoelektrische Generatorenmodul eine Heißseite und eine Kaltseite aufweist, sowie ein Kraftfahrzeug-Abgassystem mit einem abgasführenden Bauteil.

Aus dem Stand der Technik sind Abgaswärmerückgewinnungssysteme bekannt. Hierbei werden thermoelektrische Generatoren in einem Abgasweg eines Verbrennungsmotors angeordnet, um Energie aus der von den Abgasen mitgeführten Abgaswärme zurückzugewinnen.

Durch den Abgasstrom und die Verbindung des thermoelektrischen Generators zur Umgebung entsteht eine Temperaturdifferenz. Damit an dem thermoelektrischen Generator eine Temperaturdifferenz auftreten kann, verfügt dieser über eine Heiß- und über eine Kaltseite.

Thermoelektrische Generatoren wandeln mit Hilfe des Seebeck-Effektes die vorliegende Temperaturdifferenz in elektrische Energie um.

Im Aufbau eines thermoelektrischen Generators wird meistens eine Dünnschichttechnologie oder eine Folientechnik eingesetzt, die jedoch in einem Abgasstrang, in dem hohe Temperaturdifferenzen herrschen, nicht optimal arbeiten kann. Damit eine Temperaturdifferenz im Betrieb des thermoelektrischen Generators gehalten werden kann, ist eine entsprechende Dicke des thermoelektrischen Generators notwendig.

Um einen elektrischen Kurzschluss zu vermeiden und mechanische Stabilität zu realisieren, wird die Ober- und Unterseite des thermoelektrischen Generators mit Hilfe von keramischen Platten fixiert. Durch die keramischen Platten werden auf der zum Abgasstrang hin gewandten Seite des thermoelektrischen Generators eine Heißseite und auf der dem Abgasstrang abgewandten Seite eine Kaltseite gebildet.

Die im Abgasstrang enthaltene Wärmeenergie ist jedoch im Betrieb eines Kraftfahrzeugs stark von den einzelnen Betriebspunkten des Motors abhängig. So kommt es hier bei niedrigen Lastpunkten des Motors zu einer Abgastemperatur an den thermoelektrischen Generatorenmodulen von ca. 200 °C bis 300 °C, bei einem hohen Lastpunkt des Verbrennungsmotors zu einer Temperatur von ca. 600 °C bis 800 °C.

Aufgabe der vorliegenden Erfindung ist es daher, die Effizienz der Energierückgewinnung aus Kraftfahrzeugabgasen zu steigern und ein thermoelektrisches Generatorenmodul zur Verfügung zu stellen, das bei verschiedenen Temperaturverhältnissen eine ausreichend hohe Temperaturdifferenz gewährleistet, so dass stets eine elektrische Energiegewinnung durch das thermoelektrische Generatorenmodul sichergestellt ist.

Die Aufgabe wird gemäß den Merkmalen des Patentanspruchs 1 dadurch gelöst, dass das thermoelektrische Generatorenmodul an der Heißseite ein Abschlussblech aufweist.

Die Aufgabe wird weiterhin durch ein Kraftfahrzeug-Abgassystem gemäß Patentanspruch 10 gelöst, indem an einem abgasführenden Bauteil mit eingesetzten thermoelektrischen Generatorenmodulen Kühlkörper angeordnet sind.

Vorteilhafte Ausgestaltungen und Weiterbildungen des grundsätzlichen Erfindungsgedankens sind Gegenstand der abhängigen Ansprüche 2 bis 9 und 11.

Durch den erfindungsgemäßen Lösungsansatz des Abschlussbleches an der Heißseite des thermoelektrischen Generatorenmoduls wird ein besonders guter Wärmeübergang in das thermoelektrische Generatorenmodul sichergestellt. Das Abschlussblech sollte dazu vorteilhaft aus einem gut wärmeleitenden metallischen Werkstoff bestehen. Dieser Werkstoff sollte ebenfalls an die Umgebungen in einem Abgasstrang angepasst sein, beispielsweise in Bezug auf sein Korrosionsverhalten.

Vorzugsweise ist das thermoelektrische Generatorenmodul mit dem Abschlussblech in Kontakt mit einem Fluidstrom des Abgases anordnenbar. Dies bietet den Vorteil, dass das thermoelektrische Generatorenmodul mit dem Abschlussblech in einer separaten Produktionslinie vorgefertigt werden kann und dann direkt in dem abgasführenden Bauteil anordnenbar ist. Das Abschlussblech tritt dabei in direkten Kontakt mit dem Abgasstrang und kann somit dem Fluidstrom des Abgases Wärme entziehen. Es ist dabei vorteilhaft aus einem metallischen Werkstoff hergestellt.

In einer bevorzugten Ausführungsform weist die Oberfläche des Abschlussbleches eine Rippenstruktur auf. Durch die Rippenstruktur vergrößert sich die Oberfläche des Abschlussbleches, bei gleich bleibendem Platzbedarf für einen Einbauort des thermoelektrischen Generatorenmoduls. Mit einer vergrößerten Oberfläche ist es dem thermoelektrischen Generatorenmodul möglich, dem Fluidstrom mehr Wärme zu entziehen, so dass bei verschiedenen Temperaturen des Abgases stets eine ausreichende Temperaturdifferenz, für einen Betrieb des thermoelektrischen Generatorenmoduls sichergestellt wird. Die Rippenstruktur kann auch dadurch ausgebildet sein, dass das Abschlussblech zumindest bereichsweise profiliert ist.

Vorzugsweise ist die Rippenstruktur zur Strömungslenkung des Fluidstroms ausgebildet. Durch die Strömungslenkung erfolgt eine erzwungene Konvektion an der Oberfläche des Abschlussbleches. Mit erzwungener Konvektion kann je nach Strömungslenkung und Abgasströmungsgeschwindigkeit eine für den entsprechenden Anwendungsfall optimale Energierückgewinnung erfolgen. Diese kann zum Beispiel angepasst sein an die Abgasströmung eines Otto- oder Dieselmotors, da hier Unterschiede in der Strömungsgeschwindigkeit und auch in der Abgastemperatur bestehen.

Besonders bevorzugt ist das thermoelektrische Generatorenmodul mit dem Abschlussblech in einer Aussparung des abgasführenden Bauteils einsetzbar. Dies bietet den Vorteil, dass das abgasführende Bauteil einem Schalldämpfer in einem Abgasstrang ähnlich ausgebildet ist. Eine Anordnung in konventionell geplanten Karrosserietunneln einer Fahrzeugkarosserie zur Aufnahme von Abgassträngen ist damit realisierbar.

Das so ausgebildete abgasführende Bauteil weist Aussparungen zur Aufnahme des thermoelektrischen Generatorenmoduls auf. Das thermoelektrische Generatorenmodul kann in diese Aussparung eingesetzt werden und kraftschlüssig, formschlüssig oder stoffschlüssig mit dem abgasführenden Bauteil zu einem Kraftfahrzeug-Abgaswärmerückgewinnungssystem verbunden werden. Das Abschlussblech ist dabei in seinen Abmessungen nahezu identisch mit der Aussparung des abgasführenden Bauteils. Es kann durch eine Passung in die Aussparung eingepresst werden. In einer anderen Ausführungsvariante kann das Abschlussblech aber auch größer sein als die Aussparung, so dass es diese in den Randbereichen überdeckt.

Vorzugsweise sind mehrere thermoelektrische Generatorenmodule in einem abgasführenden Bauteil angeordnet. Hierdurch kann in einer Kosten sparenden Bauteilanordnung ein hohes Energierückgewinnungspotential realisiert werden. Die thermoelektrischen Generatorenmodule können beispielsweise an der Ober- und an der Unterseite des abgasführenden Bauteils bzw. komplett umseitig angeordnet werden. Dem Abgasstrang wird so in platzsparender Bauweise effektiv Wärme entzogen, da eine optimale Raumnutzung durch eine hohe Dichte von thermoelektrischen Generatorenmodulen an einem abgasführenden Bauteil ausgebildet ist.

In einer besonders bevorzugten Ausführungsvariante sind bei einem Kraftfahrzeug Abgassystem an dem abgasführenden Bauteil mit eingesetzten thermoelektrischen Generatorenmodulen Kühlkörper angeordnet. Dies bietet insbesondere den Vorteil, dass durch die Kühlkörper in jedem Betriebspunkt eine optimale Temperaturdifferenz in den thermoelektrischen Generatorenmodulen erzeugt werden kann. Ebenfalls ist die so hergestellte Bauweise Platz sparend für die Anordnung unter einem Kraftfahrzeug. In einer weiteren Ausführungsform der vorliegenden Erfindung sind mindestens zwei abgasführende Bauteile schichtweise mit Kühlkörpern übereinander angeordnet.

Vorzugsweise ist das abgasführende Bauteil aus einem Rohr mittels Innenhochdruckumformung hergestellt. Dies bietet eine besonders preisgünstige und einfache Herstellungsvariante des abgasführenden Bauteils.

In einer weiteren vorteilhaften Ausführungsform ist das abgasführende Bauteil durch Schalenbauweise hergestellt. Auch hier wird je nach Bauform eine besonders preisgünstige Produktionsvariante des abgasführenden Bauteils realisiert.

Von Vorteil ist es, wenn die Aussparungen zur Aufnahme der thermoelektrischen Generatorenmodule in die abgasführenden Bauteile durch Ausstanzen hergestellt sind. Bei dem fertig geformten abgasführenden Bauteil kann somit die Aussparung durch einen Ausstanzprozess hergestellt werden. Der Ausstanzprozess zeichnet sich durch eine hohe Genauigkeit aus. Je nach Anwendungsgebiet kann das thermoelektrische Generatorenmodul in eine jeweilige Aussparung mittels kraftschlüssiger, formschlüssiger oder stoffschlüssiger Verbindung eingesetzt werden. Die Maßhaltigkeit ist aufgrund des Ausstanzvorganges an dem fertig geformten Bauteil besonders hoch. Die Verbindung kann durch Schweißen, Löten, Presssitz oder Kleben realisiert werden.

Weitere Vorteile, Merkmale, Eigenschaften und Aspekte der vorliegenden Erfindung ergeben sich aus der folgenden Beschreibung, bevorzugte Ausführungsformen anhand der schematischen Zeichnungen. Diese dienen dem einfacheren Verständnis der Erfindung.

Es zeigen:
- Figur 1: ein abgasführendes Bauteil mit mehreren thermoelektrischen Generatorenmodulen;
- Figur 2: ein thermoelektrisches Generatorenmodul;
- Figur 3: Ausführungsbeispiele von Rippenstrukturen und
- Figur 4: thermoelektrische Generatorenmodule in einer Anordnung mit mehreren abgasführenden Bauteilen mit Kühlkörpern.

In den Figuren werden für gleiche oder ähnliche Teile dieselben Bezugszeichen verwendet, wobei entsprechende oder vergleichbare Vorteile erreicht werden, auch wenn eine wiederholte Beschreibung aus Vereinfachungsgründen entfällt.

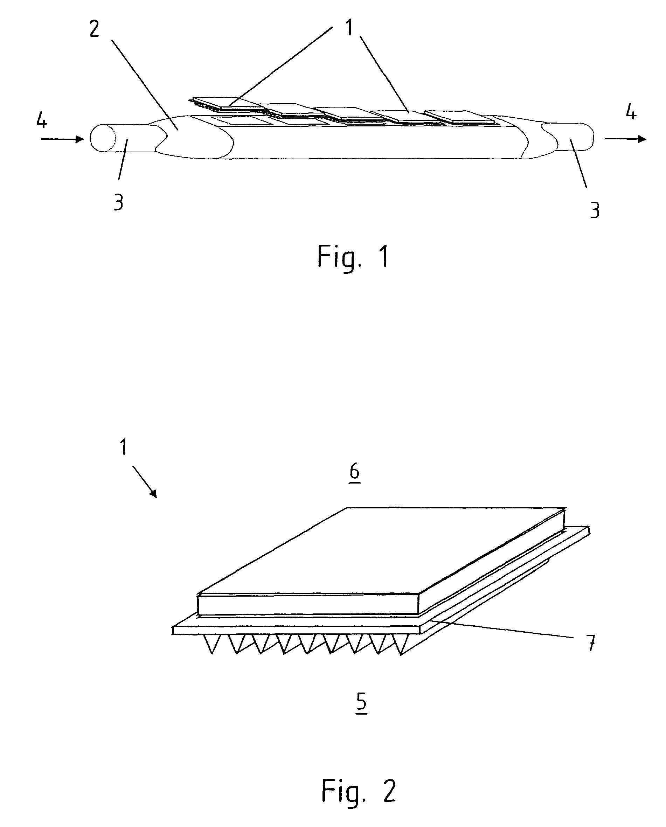

Figur 1 zeigt ein abgasführendes Bauteil 2. Das abgasführende Bauteil 2 hat eine äußere Form ähnlich einem Schalldämpfer in einem Abgasstrang 3 eines Kraftfahrzeuges. Das abgasführende Bauteil 2 wird mit in den Abgasstrang 3 eines Kraftfahrzeuges integriert. Die thermoelektrischen Generatorenmodule 1 werden an dem abgasführenden Bauteil 2 angeordnet, durch das ein Fluidstrom 4 strömt.

Figur 2 zeigt ein thermoelektrisches Generatorenmodul 1. Das thermoelektrische Generatorenmodul 1 weist eine Heißseite 5 und eine Kaltseite 6 auf. In der Anordnung in dem abgasführenden Bauteil 2 ist die Heißseite 5 zum Inneren des abgasführenden Bauteils 2 gerichtet angeordnet, die Kaltseite 6 zum Äußeren des abgasführenden Bauteils 2. Das thermoelektrische Generatorenmodul 1 weist weiterhin ein Abschlussblech 7 auf. Das Abschlussblech 7 ist an der Heißseite 5 des thermoelektrischen Generatorenmoduls 1 angeordnet. Das thermoelektrische Generatorenmodul 1 ist mit seinem Abschlussblech 7 zu einem Fluidstrom 4 im Inneren des abgasführenden Bauteils 2 hin ausgerichtet. Hierbei erfolgt über die Oberfläche des Abschlussbleches 7 eine erzwungene Konvektion und dadurch ein Wärmeaustausch zwischen Fluidstrom 4 des Abgases und Abschlussblech 7. Durch den so erzeugten Wärmeübergang entstehen an dem thermoelektrischen Generatorenmodul 1 die zuvor erwähnte Heißseite 5 und die komplementäre Kaltseite 6. In einer besonders bevorzugten Ausführungsvariante weist die Oberfläche des Abschlussbleches 7 eine Rippenstruktur auf.

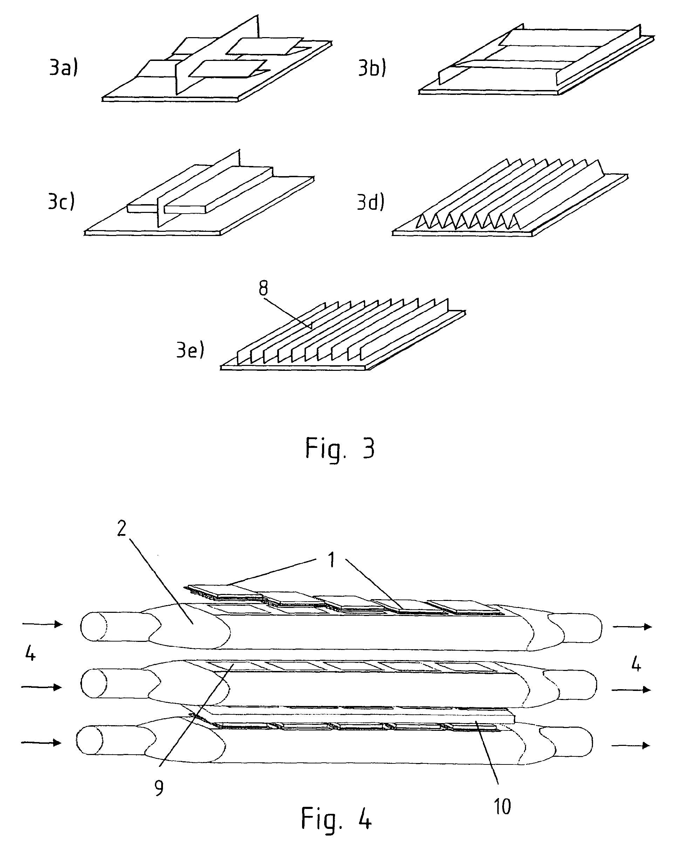

Figur 3 zeigt verschiedene Ausführungsvarianten in den Figuren 3a bis 3e der Rippenstruktur des Abschlussblechs 7. Die Figuren 3a bis 3c sind dabei gezielt zur Strömungslenkung einsetzbar und erzeugen je nach Strömungsgeschwindigkeit eine lineare oder turbulente Strömung an der Oberfläche des Abschlussbleches 7. Die Ausführungsbeispiele der Figuren 3d und 3e sind hingegen kostengünstig herstellbar. Das Strömungsverhalten ist hierbei maßgeblich von der Strömungsgeschwindigkeit über die rippenartig ausgebildete Oberfläche 8 abhängig.

Figur 4 zeigt ein Kraftfahrzeug-Abgassystem mit abgasführenden Bauteilen 2, welche thermoelektrische Generatorenmodule 1 aufweisen. Die abgasführenden Bauteile 2 weisen zur Aufnahme der thermoelektrischen Generatorenmodule 1 Aussparungen 9 auf. In diese Aussparungen 9 werden die thermoelektrischen Generatorenmodule 1 eingesetzt. Der Einsatz kann dabei durch eine Presspassung, aber auch durch ein Verkleben oder ein Verlöten oder Verschweißen realisiert werden. Um für jeden Betriebspunkt des Motors eine Temperaturdifferenz an dem thermoelektrischen Generatorenmodul 1 zu realisieren, weist die Anordnung weiterhin Kühlkörper 10 auf. Die Kühlkörper 10 sind dabei schichtweise mit den abgasführenden Bauteilen 2 übereinander oder nebeneinander angeordnet. In dem Fluidstrom 4 des Abgases enthaltene Wärme kann somit über erzwungene Konvektion an das Abschlussblech 7 übertragen werden und es erfolgt zwischen Heiß- und Kaltseite 5, 6 des thermoelektrischen Generatorenmoduls 1 eine Spannungserzeugung mit Hilfe des Seebeck-Effektes.

### Bezugszeichen:

- 1 -: thermoelektrisches Generatorenmodul
- 2 -: abgasführendes Bauteil
- 3 -: Abgasstrang
- 4 -: Fluidstrom
- 5 -: Heißseite
- 6 -: Kaltseite
- 7 -: Abschlussblech
- 8 -: Oberfläche
- 9 -: Aussparung
- 10 -: Kühlkörper

## Patentansprüche

1. Thermoelektrisches Generatorenmodul (1) zur Anordnung in einem abgasführenden Bauteil (2) in einem Abgasstrang (3) eines Kraftfahrzeuges, wobei das thermoelektrische Generatorenmodul (1) eine Heißseite (5) und eine Kaltseite (6) aufweist und an der Heißseite (5) ein Abschlussblech (7) angeordnet ist, **dadurch gekennzeichnet, dass** das thermoelektrische Generatorenmodul (1) mit dem Abschlussblech (7) in Kontakt mit einem Fluidstrom des Abgases anordnenbar ist.

2. Thermoelektrisches Generatorenmodul nach Anspruch 1, **dadurch gekennzeichnet, dass** eine Oberfläche (8) des Abschlussbleches (7) eine Rippenstruktur aufweist.

3. Thermoelektrisches Generatorenmodul nach Anspruch 2, **dadurch gekennzeichnet, dass** die Rippenstruktur zur Strömungslenkung des Fluidstromes (4) ausgebildet ist.

4. Abgasführendes Bauteil mit einem thermoelektrischen Generatorenmodul gemäß einem der voranstehenden Ansprüche, **dadurch gekennzeichnet, dass** das Abschlussblech (7) in eine Aussparung (9) des abgasführenden Bauteils (2) einsetzbar ist.

5. Abgasführendes Bauteil nach Anspruch 4, **dadurch gekennzeichnet, dass** mehrere thermoelektrische Generatorenmodule (1) in einem abgasführenden Bauteil (2) angeordnet sind.

6. Abgasführendes Bauteil nach einem der Ansprüche 4 oder 5, **dadurch gekennzeichnet, dass** das abgasführende Bauteil (2) aus einem Rohr durch Innenhochdruckumformung hergestellt ist.

7. Abgasführendes Bauteil nach einem der Ansprüche 4 oder 5, d a d u rc h **gekennzeichnet**, dass das abgasführende Bauteil (2) durch Schalenbauweise hergestellt ist.

8. Abgasführendes Bauteil nach einem der Ansprüche 4 bis 7, **dadurch gekennzeichnet, dass** die Aussparung (9) durch Ausstanzen hergestellt ist.

9. Kraftfahrzeugabgassystem mit einem abgasführendem Bauteil (2) mit eingesetztem thermoelektrischen Generatorenmodul (1), wobei an dem Generatorenmodul (1) Kühlkörper (10) angeordnet sind, **dadurch gekennzeichnet, dass** mindestens zwei abgasführende Bauteile (2) mit eingesetztem thermoelektrischen Generatorenmodul (1) schichtweise mit Kühlkörpern (10) anordnenbar sind.
